Europäisches Patentamt
European Patent Office
Office européen des brevets

(19) (11) Veröffentlichungsnummer: **0 292 821**
**A2**

(12) # EUROPÄISCHE PATENTANMELDUNG

(21) Anmeldenummer: **88107796.0**

(51) Int. Cl.⁴: **G03F 7/02**

(22) Anmeldetag: **14.05.88**

(30) Priorität: **18.05.87 US 50808**

(43) Veröffentlichungstag der Anmeldung: **30.11.88 Patentblatt 88/48**

(84) Benannte Vertragsstaaten: **AT BE CH DE FR GB IT LI NL SE**

(71) Anmelder: **HOECHST AKTIENGESELLSCHAFT**
**Postfach 80 03 20**
**D-6230 Frankfurt am Main 80(DE)**

Anmelder: **HOECHST CELANESE CORPORATION**
**Route 202-206 North**
**Somerville, N.J. 08876(US)**

(72) Erfinder: **McFarland, Michael James**
**510 Helfin Street**
**Bound Brook New Jersey 08805(US)**

(74) Vertreter: **Euler, Kurt Emil, Dr. et al**
**HOECHST AG - Werk KALLE Patentabteilung**
**Postfach 3540 Rheingaustrasse 190**
**D-6200 Wiesbaden(DE)**

(54) **Verfahren zur Bildumkehr von normalerweise positiv arbeitenden Photoresistmaterialien.**

(57) Die Erfindung betrifft ein Verfahren zur Bildumkehr von normalerweise positiv arbeitenden Photoresistmaterialien, bei dem man in der Schicht eine Verbindung, wie ein Onium-Salz, einsetzt, die bei Belichtung Säure abspaltet, die bei nachfolgender Erwärmung von einem vorhandenen hydrophoben Polymer mit z.B. Imid-, Hydroxyl- oder Carboxyl-Substituenten Gruppen, wie Butyloxycarbbonyl- oder Benzyloxycarbomyl-Gruppen, abspaltet, wodurch das Polymer in wäßrig alkalischer Lösung löslich wird,
bestehend aus den Verfahrensschritten:

a. der bildmäßigen Belichtung der auf einem Substrat befindlichen Photoresistschicht, die ein Gemisch aus einer bei Belichtung Säure abspaltenden Verbindung und einem Polymer, das mit Säure abspaltbare Gruppen besitzt enthält,

b. der Behandlung der Photoresistschicht mit einer gasförmigen Base, um die erzeugte Säure unter Salzbildung zu neutralisieren,

c. dem Entfernen der überschüssigen Base,

d. der ganzflächigen Belichtung der Photoresistschicht zur photochemischen Bildung von Säure in den bildmäßig nicht belichteten Bereichen,

e. dem Erwärmen der belichteten Photoresistschicht unter Abspalten der abspaltbaren Gruppen des Polymers in den bildmäßig nicht belichteten Bereichen und

f. der Entwicklung in einer wäßrig alkalischen Lösung zum Entfernen der bildmäßig nicht belichteten Bereiche.

Hierdurch können Bilder erhalten werden, die die relativen Vorteile positiver Resists, wie bessere Auflösung oder geingeres Quellen der Strukturen aufweisen.

EP 0 292 821 A2

## Verfahren zur Bildumkehr von normalerweise positiv arbeitenden Photoresistmaterialien

Die Erfindung betrifft ein Verfahren zur Bildumkehr von normalerweise positiv arbeitenden Photoresists. Mit Hilfe dieses Verfahrens ist es möglich, vom gleichen Resistgemisch negative wie auch, wie üblich, positive Reliefbilder herzustellen.

Viele Hersteller, insbesondere aber die Hersteller von integrierten Schaltungen mit hoher Packungsdichte, sind am Aufbau sehr kleiner Strukturen in einer dünnen, als Resist bekannten Schicht interessiert. Die Schichten sind im allgemeinen 1-2 µm dick auf dem zu bebildernden Trägermaterial aufgebracht, die Größe der Strukturen kann 1 µm oder weniger betragen. Eines der zur Herstellung dieser Strukturen verwendeten Verfahren ist die Photolithographie, bei der die gewünschte Struktur auf einer Kopiermaske abgebildet ist und durch diese Maske hindurch auf die photoresistbeschichtete Trägeroberfläche durch Belichtung übertragen wird. Beim Behandeln mit einer Entwicklerlösung bleibt der verwendete Photoresist entweder an den belichteten Stellen auf dem Träger zurück oder wird an den belichteten Stellen entfernt. Im ersten Fall spricht man von einem negativ arbeitenden Photoresist, im zweiten von einem positiv arbeitenden Photoresist.

Bei den bekannten negativ arbeitenden Photoresistschichten hat man beobachtet, daß diese beim Entwickeln eine deut liche Tendenz zum Quellen zeigen, weil organische Lösemittel als Entwickler eingesetzt werden. Es ist daher schwierig, Leiterbilder mit einem schmalen, freien Zwischenraum zwischen zwei Resistlinien herzustellen, da der beim Entwickeln zurückbleibende Resist so stark anquillt, daß der schmale Zwischenraum überbrückt wird, d. h. die beiden, eigentlich voneinander getrennten Resistlinien kommen beim Entwickeln miteinander in Berührung. Obwohl die Resistschicht nach der Entnahme aus dem Entwickler wieder schrumpft, entsteht an den Stellen, wo der angequollene Resist einen anderen Teil der Struktur berührt hat, zwischen den beiden Strukturteilen eine unerwünschte faden- oder filmartige Brücke.

Wegen dieses Quellproblems bei negativ arbeitenden Resists und weil positiv arbeitende Resists beim Entwickeln normalerweise nicht anquellen, ist es üblich, für die Mikrophotolithographie mit hoher Auflösung positiv arbeitende Resists zu verwenden. Für einige Strukturen wäre es jedoch günstiger, mit einem Negativresist arbeiten zu können. So läßt sich zum Beispiel die Kopiermaske für ein bestimmte Struktur eventuell leichter herstellen oder wäre im Gebrauch zuverlässiger, wenn sie größtenteils dunkle und nur einige klare Bereiche aufwiese, anstelle von größtenteils klaren und nur einigen dunklen Bereichen. Man kann sich leicht vorstellen, daß dies der Fall sein könnte, wenn man bedenkt, wie sich Staubpartikel auf eine größtenteils klare Maske, im Gegensatz zu einer größtenteils dunklen Maske, auswirken. Jede Staubpartikel im klaren Bereich der Maske wird als Fehler auf der Resistschicht wiedergegeben, ungeachtet der Tatsache, ob es sich um ein Positiv- oder Negativresist handelt. Bei der überwiegend klaren Maske ist also ein im Verhältnis größerer Bereich empfindlich gegen Verunreinigung durch Partikel als in der überwiegend dunklen Maske.

Es ist bekannt, daß herkömmliche, positiv arbeitende Photoresists, die ein Novolakharz als Bindemittel und ein Diazoketon oder Diazochinon als lichtempfindliche Verbindung enthalten, so verarbeitet werden können, daß sie negative Bilder ergeben, wie es zum Beispiel in der US-A 4,104,070 und von L. F. Thompson, G. G. Willson und M. J. Bowden, in ACS Symposium Series 219, 117 (1983) beschrieben ist.

Diese Bilder besitzen eine gute Qualität. Der Resist quillt beim Entwickeln nicht. Die Bildumwandlung ergibt sich aus den folgenden chemischen Prozessen:

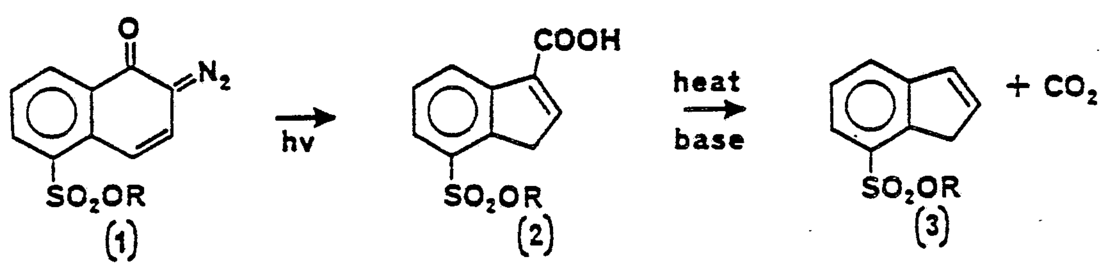


Aufgrund des hydrophoben Charakters des Sensibilisators (1) ist die Resistschicht anfangs in wäßrigem Entwickler unlöslich (das Novolakharz selbst ist hydrophil und bereits im Entwickler löslich). Bei der Überführung in das Lichtzersetzungsprodukt (2) wird der Sensibilisator in eine hydrophile und in der Entwicklerlösung lösliche Indencarbonsäure umgewandelt. Da das Novolakharz bereits löslich ist, wird die

Resistschicht nun an den belichteten Stellen im Entwickler löslich. Beim Bildumkehrverfahren wird das Material in Gegenwart eines Katalysators, wie zum Beispiel(R)Monazoline oder Ammoniakdampf, erhitzt, so daß aus der Indencarbonsäure (2) durch Decarboxylierung eine hydrophobe Indenverbindung (3) entsteht, die die Schicht wieder unlöslich macht. Dieses Verfahren ist in "Semiconductor International" vom April 1987, Seiten 88-89, beschrieben. Es wird jedoch die Ansicht geäußert, daß Carbonsäuren durch den Einsatz vom Aminen neutralisiert werden und damit die Löslichkeit des belichteten Sensibilisators vermindert wird. An sich wäre das Aminsalz sehr wohl in dem Entwickler löslich, und daher muß der oben erwähnte Decarboxylierungsprozeß bis zum Vorliegen des endgültigen Indenprodukts ablaufen, damit die bestrahlten Bereiche unlöslich werden.

Nachdem der belichtete Teil der Schicht unlöslich gemacht worden ist, wird die Resistschicht insgesamt ohne Bildvorlage ganzflächig belichtet. Während dieses Belichtungsschrittes werden die zuvor bei der bildmäßigen Belichtung unbelichtet gebliebenen Bereiche durch Um wandlung des Sensibilisators (1) in die Carbonsäure (2) löslich.

Die zuvor belichteten Bereiche bleiben hydrophob und unlöslich, da der Sensibilisator dort bereits verbraucht ist. Alle Beispiele für diese Art der Bildumkehr verwenden ein alkalilösliches Novolakharz, dessen Lösungsverhalten durch den Diazochinonsensibilisator gesteuert wird. Solange der Sensibilisator sich im hydrophoben Zustand befindet, ist die Schicht unlöslich, und sie wird löslich, wenn der Sensibilisator im hydrophilen Zustand ist. Wenn das Bildumkehrverfahren also funktionieren soll, muß die Decarboxylierungsreaktion [(2) → (3)] ablaufen, um den Sensibilisator und damit die belichtete Schicht wieder in den unlöslichen Zustand zu versetzen.

Es ist auch nachgewiesen worden, daß eine abschließende ganzflächige Flutbelichtung nicht erforderlich ist, wenn der Sensibilisator so gewählt wird, daß die daraus photolytisch gebildete Säure die belichteten Bereiche während einer Nacherhitzung bei hoher Temperatur vernetzen kann. Diese Art der Bildumkehr verwendet keine Behandlung mit einem Amin ("Mechanism and Lithographic Evaluation of Image Reversal in(R)AZ 5214 Photoresist" , von M. Spak u. a. in den Protokollen der SPE Regional Technical Conference zum Thema "Photopolymers: Principles, Processes and Materials", Ellenville, N.Y. (1985), Seiten 247-269).

Bei den Bildumkehrverfahren, bei denen mit hydrophilen Novolakharzen und Diazochinonen als Sensibilisatoren gearbeitet wird, entsteht ein unlöslicher, hydrophober Bereich durch Decarboxylierung von Indencarbonsäuren oder durch säurekatalysierte Vernetzung (R. M. R. Gijsen u.a. "A Quantitative Assessment of Image Reversal, A Candidate for a Submicron Process with Improved Line-width Control", SPIE Band 631, Advances in Resist Technology and Processing III (1986), Seiten 108-116).

Den bekannten Novolak-Photoresist-Mischungen sind insofern Grenzen gesetzt, als sie zur Herstellung von Bildern mit hoher Auflösung, nicht jedoch mit kurzwelligem UV-Licht von ≦ 300 nm belichtet werden können, da das Novolakharz in diesem Spektralbereich ein hohes Absorptionsmaß aufweist. Um diese Schwierigkeit zu umgehen, sind positiv arbeitende Resists entwickelt worden in denen verschiedene Sensibilisatoren und verschiedene Harze als Bindemittel verwendet werden. Bei den Sensibilisatoren handelt es sich um Verbindungen, wie zum Beispiel Oniumsalze, die bei der Photolyse eine starke Säure bilden, während die Harze Polymere sind, die wegen ihrer Durchlässigkeit für UV-Strahlen und anderer physikalischer Eigenschaften ausgewählt werden. Die Harze enthalten als wesentlichen Bestandteil eine durch Säure abspaltbare Gruppe, durch deren Entfernung das Polymere von einem in wäßrigen Entwicklern unlöslichen in einen in wäßrigen Entwicklern löslichen Zustand übergeführt werden kann. Gemäß US-A 4,491,628 können solche Resists mit einem organischen, unpolaren Lösemittel als Entwickler, anstelle des zur Herstellung von Positivbildern verwendeten wäßrig-alkalischen Entwicklers, zu einem Negativbild verarbeitet werden. Dies hat jedoch den Nachteil, daß mit Materialien gearbeitet werden muß, die wegen ihrer Entflammbarkeit, Toxizität oder Flüchtigkeit schwieriger zu handhaben sind als die bei der positiven Verarbeitung verwendeten Stoffe. Bei Verwendung dieser organischen Entwickler kann es auch wieder zum Quellen und zur Haarrißbildung in den Polymerschichten kommen.

Gegenstand der Erfindung ist ein neues Verfahren zur Bildumkehr von normalerweise positiv arbeitenden Photoresistmaterialien, bei dem man in der Schicht eine Verbindung einsetzt, die bei Belichtung Säure abspaltet, die bei nachfolgender Erwärmung von einem vorhandenen hydrophoben Polymer Gruppen abspaltet, wodurch das Polymer in wäßrig alkalischer Lösung löslich wird, bestehend aus den Verfahrensschritten:

a. der bildmäßigen Belichtung der auf einem Substrat befindlichen Photoresistschicht, die ein Gemisch aus einer bei Belichtung Säure abspaltenden Verbindung und einem Polymer, das mit Säure abspaltbare Gruppen besitzt, enthält,

b. der Behandlung der Photoresistschicht mit einer gasförmigen Base, um die erzeugte Säure unter Salzbildung zu neutralisieren,

c. dem Entfernen der überschüssigen Base,

d. der ganzflächigen Belichtung der Photoresistschicht zur photochemischen Bildung von Säure in den bildmäßig nicht belichteten Bereichen,

e. dem Erwärmen der belichteten Photoresistschicht unter Abspalten der abspaltbaren Gruppen des Polymers in den bildmäßig nicht belichteten Bereichen und

f. der Entwicklung in einer wäßrig alkalischen Lösung zum Entfernen der bildmäßig nicht belichteten Bereiche.

Vorzugsweise setzt man ein Imidgruppen haltiges Polymer, ein, dessen Imidgruppen mit Säure abspaltbaren Gruppen blockiert sind.

Nach dem erfindungsgemäßen Verfahren ergeben diese Photoresists ein Negativbild anstelle eines Positivbildes. Die Resistschicht wird durch eine mit einer Struktur versehenen Kopiermaske belichtet und danach folgenden Behandlungsschritten unterworfen: Kontaktieren mit einer gasförmigen Base, wie Ammoniak oder einem Amin zwecks Neutralisation der gebildeten Säure, um ein Fragmentieren des Polymeren mit abspaltbarer Gruppe zu verhindern, Entfernen der überschüssigen Base, ganzflächiges Flutbelichten der Schicht, Nacherhitzen, um das Polymere in den alkalilöslichen Zustand zu überführen, und Entwickeln der Schicht mit einer wäßrig-alkalischen Lösung, so daß ein Negativbild der Kopiermaske entsteht.

Wenn ein Positivphotoresist der oben beschriebenen Art durch eine Strukturmaske belichtet wird, entsteht in den bestrahlten Bereichen durch Photolyse eine Säure. Durch Behandeln des Resists mit einer Base wird die Säure in den belichteten Bereichen unter Salzbildung neutralisiert, und der normalerweise im Nacherhitzungsschritt erzielte Fragmentierungseffekt am Polymeren tritt nicht ein. Das Polymere bleibt unverändert und hydrophob. Um in den zuvor unbelichteten Bereichen auf photolytischem Wege Säure zu bilden, wird die Photoresistschicht dann ganzflächig belichtet und anschließend erwärmt und entwickelt. Es entsteht ein Negativbild.

Das erfindungsgemäße Verfahren verwendet eine Positivresistbeschichtung zur Herstellung eines Negativbildes und nutzt dabei die relativen Vorteile positiver Resists, wie die bessere Auflösung, die Entwicklung mit einer wäßrigen Lösung, die verminderte Toxizität des Entwicklers, das geringere Quellen der Struktur usw.

Das in dem Photoresist verwendete Polymer ist vorzugsweise ein Imidgruppen haltiges Polymer, dessen Imidgruppen mit Säure abspaltbaren Gruppen blockiert ist, insbesondere einer tert.-Butyloxycarbonyl-Gruppe oder einer Benzyloxycarbonyl-Gruppe, geschützt. sind. Weitere in dem erfindungsgemäßen Verfahren anwendbare Polymere sind solche, deren Funktionalitäten, zum Beispiel phenolische Funktionen oder Funktionen von Carbonsäure, durch Säure abspaltbare Gruppen blockiert sind.

Dementsprechend werden auch vorzugsweise Phenol enthaltendes Polymer, dessen Hydroxylgruppe mit einer Säure abspaltbaren Gruppe oder ein Carboxylgruppen enthaltendes Polymer, die mit einer Säure abspaltbaren Gruppe blokkiert sind, eingesetzt.

Als bei Belichtung Säure abspaltbare Verbindungen können verschiedene latente photolytische Säuren verwendet werden, sofern sie keine Carbonsäuren ergeben. Oniumsalze, wie Aryldiazonium-, Diaryljodonium- oder Triarylsulfonium-Salze werden bevorzugt, insbesondere deren Trifluoromethansulfonate ($CF_3SO_3^-$).

Man hat nun herausgefunden, daß Photoresists mit hydrophoben, blockierten Polymeren nach dem erfindungsgemäßen Verfahren so behandelt werden können, daß sie nach dem Entwickeln in dem normalen wäßrig-alkalischen Entwickler ein Negativbild ergeben. Dieses überraschende Ergebnis tritt ein, obwohl die in den bekannten Resistsystemen photolytisch gebildeten Säuren, wie zum Beispiel Fluorwasserstoffsäure oder Trifluormethansulfonsäure, nicht zu der für die praktische Durchführung von US-A 4,104,070 unbedingt notwendigen Decarboxylierungsreaktion befähigt sind, weil sie keine Carbonsäuren sind. Ferner wird die Säure bei Raumtemperatur mit einer Base behandelt, wogegen beim Decarboxylierungsprozeß der Photoresist in Gegenwart der Base erhitzt werden mußte. Die Erfindung bedeutet also insofern eine Verbesserung gegenüber dem Stand der Technik, als sie es ermöglicht, die Bildumkehrtechniken auf die Resists aus der US-A 4,491,628 anzuwenden.

Das Verfahren umfaßt die folgenden Schritte:

1. Beschichten des Schichtträgers mit einer dünnen Photoresistschicht, die ein hydrophobes blockiertes Polymeres und eine latente, photolytische Säure enthält.

2. Belichten der Photoresistschicht durch eine Maske, wobei in den belichteten Bereichen die Säure photolytisch gebildet wird, das Polymere jedoch nicht angegriffen wird.

3. Ohne Durchführung eines Nacherhitzungsschrittes zum Fragmentieren des Polymeren, Behandlung der Resistschicht mit der gasförmigen Base, z. B. Ammoniak oder Triethylamin, wobei die in Schritt 2 erzeugte Säure unter Salzbildung neutralisiert wird.

4. Entfernen überschüssiger Base, zum Beispiel indem der Schichtträger einem Vakuum oder einem inerten Gasstrom ausgesetzt wird.

5. Flutbelichten der gesamten Photoresistschicht, wobei in den in Schritt 2 unbelichtet gebliebenen Bereichen auf photolytischem Wege Säure gebildet wird.

6. Nacherhitzen des Substrats und der Photoresistschicht, wobei das Polymere in dem in Schritt 2 unbelichtet gebliebenen Bereich fragmentiert wird.

7. Entwickeln der Schicht in einer wäßrig-alkalischen Lösung, wobei die Photoresistschicht bis auf den in Schritt 2 belichteten Bereich entfernt wird und man so das Negativbild der Kopiermaske enthält.

Man hat festgestellt, daß erfindungsgemäß die folgenden chemischen Schritte von Bedeutung sind. In Schritt 2 der oben genannten Schrittfolge wird der Sensibilisator in den durch die lichtdurchlässigen Stellen der Maske belichteten Bereichen in eine starke Säure umgewandelt. Die Säure darf das hydrophobe Polymere bei normalen Temperaturen nicht fragmentieren, da es sonst in einem wäßrigen Entwickler löslich wird und der Neutralisierungsschritt 3 ohne Wirkung ist. In Schritt 3 dringt die gasförmige Base in die Schicht ein, und die photolytisch gebildete Säure wird unter Salzbildung neutralisiert. Dieses Salz besitzt nicht mehr die Fähigkeit, als Katalysator für die entscheidende Entfernung der durch Säure abspaltbaren Gruppe des Polymeren zu wirken, d. h. das Polymere zu fragmentieren.

Zu bemerken ist, daß ein solcher Schritt bei Photoresists, die Novolakharze und Diazochinon-Sensibilisatoren enthalten, unzureichend wäre, da das Salz hydrophil ist und die Schicht sich auflösen würde. Die bekannten Photoresists erfordern die Bildung einer hydrophoben Substanz, die das Harz daran hindert, sich aufzulösen. Die für diese Erfindung bevorzugten photolytischen Säuren ergeben dagegen starke Säuren, wie zum Beispiel HF, $CF_3SO_3H$, p-Toluolsulfonsäure und $H_2SO_4$, die mit Aminen zu Salzen reagieren können, aber keine unlöslichen Substanzen bilden.

Die wesentlichen Merkmale der Base sind ein angemessen hoher Dampfdruck bei Raumtemperatur und die Fähigkeit, in die Schicht einzudringen und mit der photolytisch gebildeten Säure zu reagieren. Das setzt voraus, daß die Moleküle der Base klein sind, wie dies zum Beispiel bei Ammoniak oder einem organischen primären, sekundären oder tertiären Amin mit weniger als 12 Kohlenstoffatomen der Fall ist. In Schritt 4 wird die Photoresistschicht für kurze Zeit einem Vakuum oder einem inerten Gasstrom ausgesetzt, um überschüssige gasförmige Base zu entfernen. Bevorzugt wird in Schritt 3 ein Amin verwendet, das sich leicht entfernen läßt. So werden zum Beispiel tertiäre Amine, wie Triethylamin, den primären Aminen, wie Methylamin, vorgezogen. In Schritt 5 die Photoresistschicht ganzflächig flutbelichtet, wobei aus dem restlichen Sensibilisator photolytisch Säure gebildet wird. Dabei handelt es sich um den Sensibilisator, der bei der ursprünglichen bildmäßigen Belichtung nicht belichtet wurde, weil er von den dunklen Bereichen der Kopiermaske abgedeckt war. Die Verteilung der Säurekonzentration in der Schicht ist damit entgegengesetzt zu derjenigen, die man bei Belichtung mit einer Strukturmaske in einem normalen, einstufigen Prozeß erhält. Im Nacherhitzungsschritt 6 wird die Säure als Katalysator für die Entfernung der säureabspaltbaren Gruppen aus dem Polymeren wirksam, wie es in der US-A 4,491,628 beschrieben ist. Dadurch wird das Polymere in diesen Bereichen in einem wäßrigen Entwickler löslich. Dagegen ist in den bei der ursprünglichen Belichtung mit Kopiermaske bestrahlten Bereichen die photolytisch gebildete Säure durch den Neutralisierungsschritt 3 unwirksam geworden, so daß die säureabspaltbaren Gruppen nicht entfernt werden und das Polymere unlöslich bleibt. In Schritt 7 wird der Wafer in eine wäßrig-alkalische Lösung getaucht, und die Bereiche der Schicht, in denen die abspaltbaren Gruppen entfernt wurden, werden ausgewaschen. Das Ergebnis ist eine Reliefstruktur aus einer Photoresistschicht auf dem Substrat, die ein Umkehrbild der Maske darstellt. D.h. die verbleibenden Bereiche und die ausgewaschenen Bereiche zeigen die Umkehrung des Bildes, das man erhalten würde, wenn die Schritte 3, 4 und 5 nicht durchgeführt würden.

Bei der praktischen Durchführung des erfindungsgemäßen Verfahrens können außer Ammoniak und Triethylamin noch eine Anzahl weiterer geeigneter gasförmiger Basen verwendet werden. Bevorzugte Verbindungen sind zum Beispiel verschiedene primäre, sekundäre oder tertiäre Amine, insbesondere solche, die 1 bis 12 C-Atome besitzen und deren Dämpfe in die Photoresistschicht eindringen können.

Der polymere Bestandteil des Photoresists kann aus einer Anzahl bekannter Harze gewählt werden, die eine photolytisch gebildete Säure benötigen, um sie aus einer unlöslichen in eine lösliche Substanz chemisch umzuwandeln. Solche Polymere sind zum Beispiel ein Copolymeres aus N-tert.-Butyloxycarbonylmaleinsäureimid und Styrol, ein Homopolymeres aus N-tert.-Butyloxycarbonylmaleinsäure imid, Copolymere aus N-tert.-Butyloxycarbonylmaleinsäureimid und einem aliphatischen Vinylether mit 3 bis 20 C-Atomen vorzugsweise Decylvinylether, Copolymere aus N-tert.-Butyloxycarbonylmaleinsäureimid und 2,4-disubstituiertem Styrol, in denen das Styrol in den 2- und 4-Stellungen, unabhängig voneinander, mit $C_1$-$C_5$-Alkylgruppen oder H substituiert ist oder ein Copolymeres aus N.-tert.-Butyloxycarbonylmaleinsäureimid und 4-tert.-Butylstyrol. Weitere geeignete Polymere umfassen zum Beispiel ein Phenol enthaltendes Polymeres, in dem die Hydroxylfunktionalitäten durch eine säureabspaltbare Gruppe geschützt sind, wie zum Beispiel Poly(tert.-butyloxycarbonyloxy-α-alkylstyrol) oder dessen Copolymeres, Poly(tert.-butyloxycarbonyloxystyrol) oder dessen Copolymeres, Polymere mit anderen, durch eine säureabspaltbare Gruppe geschützten sauren Imidfunktionalitäten (-CO-NH-CO-), wie zum Beispiel Poly(dimethyl-N-tert.-butyloxycarbonylglutarsäureimid), Polymere mit Carbonsäurefunktionalitäten, die durch eine säureabspaltbare Gruppe geschützt sind, wie zum Beispiel Poly(tert.-butyl-p-vinylbenzoat) oder ein Copolymeres davon, Poly-(tert.butylmethacrylat) oder ein Copolymeres davon und dergl. An den Polymeren können auch andere Schutzgruppen, wie Benzyloxycarbonyl-Gruppen, vorhanden sein.

Es können zwar verschiedene latente photolytisch herstellbare Säuren verwendet werden, jedoch werden Diazochinone, die Carbonsäuren bilden und das hydrophobe Polymere nicht effektiv fragmentieren, möglichst nicht eingesetzt. Bevorzugt werden Oniumsalze, wie zum Bei spiel Diazonium-, Jodonium- oder Sulfoniumsalze, eingesetzt, insbesondere solche mit Anionen, wie zum Beispiel Trifluoromethylsulfonat ($CF_3SO_3^-$), Methansulfonat oder allgemeiner $RSO_3^-$, worin R Alkyl, Aryl oder substituiertes Alkyl oder Aryl bedeutet. Diphenyljodoniumtrifluormethansulfonat und Triphenylsulfoniumtrifluormethansulfonat werden besonders bevorzugt.

## Beispiel 1

Zur Herstellung eines Positivphotoresists wurden 9 Gewichtsteile (Gt) N-tert.-Butyloxycarbonylmaleinsäureimid-Styrol-Copolymers und 1 Gt Diphenyljodoniumtrifluormethansulfonat in 27 Gt 2-Methoxyethylether gelöst. Diese Lösung wurde durch ein PTFE-Filter mit einer Porenweite von 0,2 µm filtriert und dann auf saubere, 2" große Silizium-Wafer aufgeschleudert, die zur Verbesserung der Resisthaftung zuvor mit dampfförmigem 1,1,1,3,3,3-Hexamethyldisilazan behandelt worden waren. Um Lösemittelreste zu entfernen, wurden die schleuderbeschichteten Wafer bei 80 °C für 20 Minuten vorgetrocknet. Jeder Wafer wurde durch eine chrombeschichtete Strukturmaske aus Quarz im Vakuumkontakt mit der Resistschicht bei 260 ± 15 nm mit einer Belichtungsenergie von 100 mJ/cm² belichtet. Nach dem Belichten wurden die Wafer bei Raumtemperatur 1 Minute mit Ammoniakdampf behandelt und anschließend in eine Vakuumkammer eingebracht, die für die Dauer von 20 Minuten auf 100 Torr (13,332 kPa) evakuiert wurde. Nach der Entnahme aus der Kammer wurden die Wafer bei 260 nm mit 200 mJ/cm² flutbelichtet und danach bei 130 °C für 2 Minuten nacherhitzt, so daß die säurekata lysierte Fragmentierung stattfinden konnte. Im Anschluß an die Nacherhitzung wurden die Wafer in einer 0,1 normalen Lösung von quaternären Ammoniumbasen (1:1 Tetramethylammoniumhydroxid/Tetrabutylammoniumhydroxid) 20 Sekunden entwickelt. Die entstandene Struktur war das Negativbild der bei der ersten Belichtung verwendeten Maske.

## Beispiel 2

Es wurden resistbeschichtete Wafer genau wie in Beispiel 1 hergestellt und ebenso wie in Beispiel 1 durch eine Maske belichtet, jedoch anschließend für die Dauer von 10 Minuten Triethylamin-Dämpfen ausgesetzt. Die weitere Verarbeitung erfolgte wie in Beispiel 1 beschrieben, und auch hier war das erhaltene Bild das Negativ der Kopiermaske.

## Beispiel 3

Zur Herstellung eines Positivphotoresists wurden 15 Gewichtsteile (Gt) Poly(tert.-butyloxycarbonyloxystyrol) und 1 Gt Diphenyljodoniumtrifluormethansulfonat in 37,3 Gt 2-Methoxyethylether ("Diglyme") gelöst. Diese Lösung wurde durch ein PTFE-Filter mit einer Porenweite von 0,2 µm filtriert und dann auf saubere, 2" große Silizium-Wafer aufgeschleudert, die zur Verbesserung der Resisthaftung auf dem Schichtträger zuvor mit 1,1,1,3,3,3-Hexamethyldisilazan behandelt worden waren. Um das Lösemittel zu entfernen, wurden die schleuderbeschichteten Wafer bei 55 °C für 15 Minuten vorgetrocknet. Jeder Wafer wurde durch eine chrombeschichtete Strukturmaske aus Quarz im Vakuumkontakt mit der Resistschicht bei 260 ± 15 nm mit einer Belichtungsenergie von 100 mJ/cm² belichtet. Nach dem Belichten wurden die Wafer bei Raumtemperatur 1 Minute mit Ammoniakdampf behandelt und anschließend für die Dauer von 30 Minuten in einen Strom von trockenem Stickstoff eingebracht, um überschüssigen Ammoniak zu entfernen. Nach der Entnahme aus dem Stickstoff wurden die Wafer bei 260 nm mit 200 mJ/cm² ganzflächig belichtet und danach bei 85 °C für 2 Minuten nacherhitzt, so daß die säurekatalysierte Fragmentierung stattfinden konnte. Im Anschluß an die Nacherhitzung wurden die Wafer in einer 0,25 molaren Kaliumhydroxidlösung während 5 bis 10 Sekunden entwickelt. Die entstandene Struktur war das Negativbild der bei der ersten Belichtung verwendeten Maske.

Beispiel 4

Es wurden resistbeschichtete Wafer genau wie in Beispiel 3 hergestellt und verarbeitet, mit dem Unterschied, daß anstelle von Ammoniak Triethylamin-Dampf verwendet wurde und der Wafer im Stickstoffstrom leicht erwärmt wurde, um überschüssiges Amin leichter zu entfernen. Die erhaltene Struktur war das Negativbild der bei der ersten Belichtung verwendeten Maske.

**Ansprüche**

1. Verfahren zur Bildumkehr von normalerweise positiv arbeitenden Photoresistmaterialien, bei dem man in der Schicht eine Verbindung einsetzt, die bei Belichtung Säure abspaltet, die bei nachfolgender Erwärmung von einem vorhandenen hydrophoben Polymer Gruppen abspaltet, wodurch das Polymer in wäßrig alkalischer Lösung löslich wird,
bestehend aus den Verfahrensschritten:

a. der bildmäßigen Belichtung der auf einem Substrat befindlichen Photoresistschicht, die ein Gemisch aus einer bei Belichtung Säure abspaltenden Verbindung und einem Polymer, das mit Säure abspaltbare Gruppen besitzt enthält,

b. der Behandlung der Photoresistschicht mit einer gasförmigen Base, um die erzeugte Säure unter Salzbildung zu neutralisieren,

c. dem Entfernen der überschüssigen Base,

d. der ganzflächigen Belichtung der Photoresistschicht zur photochemischen Bildung von Säure in den bildmäßig nicht belichteten Bereichen,

e. dem Erwärmen der belichteten Photoresistschicht unter Abspalten der abspaltbaren Gruppen des Polymers in den bildmäßig nicht belichteten Bereichen und

f. der Entwicklung in einer wäßrig alkalischen Lösung zum Entfernen der bildmäßig nicht belichteten Bereiche.

2. Verfahren nach Anspruch 1, dadurch gekennzeichnet, daß man ein Imidgruppen haltiges Polymer einsetzt, dessen Imidgruppen mit Säure abspaltbaren Gruppen blockiert sind.

3. Verfahren nach Anspruch 2, dadurch gekennzeichnet, daß man als Polymer, das mit Säure abspaltbare Gruppem enthält, Poly(N-tert.-butyloxycarbonyl-maleinsäureimidco-styrol), Poly(N-tert.-butyloxycarbonyl-maleinsäureimid-co-4-tert.-butyl-styrol), Poly(N-tert.-butyloxycarbonylmaleinsäureimid-co-decyl-vinylether), Poly(dimethyl-N-tert.butyloxycarbonyl-glutarsäureimid), oder Poly(N-tert.butyloxycarbonyl-maleinsäureimid) einsetzt.

4. Verfahren nach Anspruch 2, dadurch gekennzeichnet, daß man als blockierende Gruppe eine tert.-Butyloxycarbonyl-Gruppe oder eine Benzyloxycarbonyl-Gruppe verwendet.

5. Verfahren nach Anspruch 1, dadurch gekennzeichnet, daß man ein Phenol enthaltendes Polymer einsetzt, dessen Hydroxylgruppe mit einer Säure abspaltbaren Gruppe blockiert ist.

6. Verfahren nach Anspruch 5, dadurch gekennzeichnet, daß man als Polymer mit Säure abspaltbarer Gruppe Poly (tert.-butyloxycarbonyloxy-$\alpha$-alkyl-styrol) oder Poly(tert.-butyloxycarbonyloxystyrol) einsetzt.

7. Verfahren nach Anspruch 5, dadurch gekennzeichnet, daß man als blockierende Gruppe eine tert.-Butyloxycarbonyl- oder eine Benzyloxycarbonyl-Gruppe verwendet.

8. Verfahren nach Anspruch 1, dadurch gekennzeichnet, daß das Polymer Carboxylgruppen enthält, die mit einer Säure abspaltbaren Gruppe blockiert sind.

9. Verfahren nach Anspruch 8, dadurch gekennzeichnet, daß man als Polymer Poly(tert.-butyl-methacrylat) oder Poly(tert.-butyl-p-vinylbenzoat) einsetzt.

10. Verfahren nach Anspruch 1, dadurch gekennzeichnet, daß die bei Belichtung entstehende Säure durch Belichten eines Oniumsalzes gebildet wird.

11. Verfahren nach Anspruch 10, dadurch gekennzeichnet, daß man als Oniumsalz ein Aryldiazonium-, ein Diaryljodonium- oder Triarylsulfonium-salz einsetzt.

12. Verfahren nach Anspruch 11, dadurch gekennzeichnet, daß man als Oniumsalz Diphenyljodoniumtrifluormethansulfonat oder Triphenylsulfoniumtrifluormethansulfonat einsetzt.

13. Verfahren nach Anspruch 1, dadurch gekennzeichnet, daß man als gasförmige Base ein primäres, sekundäres oder tertiäres Amin mit 1 bis 12 Kohlenstoffatomen einsetzt.

14. Verfahren nach Anspruch 1, dadurch gekennzeichnet, daß man als gasförmige Base Ammoniak einsetzt.

15. Verfahren nach Anspruch 13, dadurch gekennzeichnet, daß man Triethylamin einsetzt.